# EUROPÄISCHE PATENTANMELDUNG

(11) **EP 0 522 300 A2**
(43) Veröffentlichungstag der Anmeldung: **13.01.1993**
(21) Anmeldenummer: 92109776.2
(22) Anmeldetag: 10.06.1992
(51) Int. Cl.: H01P 5/02, H01P 5/103

(54) **Anordnung zur Einkopplung von Mikrowellenenergie**

(30) Priorität: 10.07.1991 DE 4122802
(71) Anmelder: Schott Glaswerke, D-55122 Mainz (DE)
(72) Erfinder: Krümmel, Harald, W-6500 Mainz 25 (DE); Mörsen, Ewald, W-6507 Ingelheim (DE); Vogt, Helge, W-6506 Nackenheim/Rhein (DE); Weidmann, Günter, W-6509 Armsheim (DE)
(74) Vertreter: Fuchs, Luderschmidt & Partner Patentanwälte

(57) **Zusammenfassung**

Es wird eine Anordnung zur Einkopplung von Mikrowellenenergie in eine Reaktionskammer (14) beschrieben, die eine elektrisch stabile Abstimmung aufweist und in Grenzen tolerant ist gegen Änderungen von kritischen Abmessungen und Leistungsänderungen. Der Koaxialleiter (4) zwischen dem Hohlleiter (2) und der Reaktionskammer (14) ist derart ausgebildet, daß er zumindest zusammen mit der Reaktionskammer (14) für die verwendete Mikrowellenfrequenz einen verlustbehafteten Resonator bildet. Der Koaxialleiter (4) kann einen Absorber (10) aufweisen oder aber aus schlecht leitendem Material gefertigt sein. Auch besteht die Möglichkeit, die Güte des Resonators dadurch zu verschlechtern, daß zwischen der Metallplatte (13) und dem Außenleiterabschnitt (6) ein Ringspalt (15) freigelassen wird.

## Beschreibung

Die Erfindung betrifft eine Anordnung zur Einkopplung von Mikrowellenenergie in eine Reaktionskammer, nach dem Oberbegriff des Anspruchs 1.

Bei der Beschichtung von Substraten, insbesondere von kalottenförmigen Substraten, werden diese in einer Reaktionskammer dem Plasma eines Reaktionsgases ausgesetzt, das mittels Mikrowellen angeregt wird. Die Qualität der Beschichtung hängt u.a. von der Konstanz der eingestrahlten Mikrowellenenergie ab. Wenn sich hinsichtlich der Mikrowelleneinstrahlung Veränderungen einstellen, so weisen die Beschichtungen der nacheinander behandelten Kalotten unterschiedliche Qualitäten auf. Einen wesentlichen Einfluß auf die Konstanz der eingestrahlten Mikrowellenenergie haben die Bauteile, die für die Einkopplung der Mikrowellenenergie in die Reaktionskammer verantwortlich sind.

Aus der DE 39 05 303 A1 ist eine Vorrichtung zur Erzeugung eines Plasmas durch Mikrowellen bekannt, bei der im Koaxialleiter eine Entladungsröhre angeordnet ist, die in eine Reaktionskammer übergeht. Koaxialleiter und Reaktionskammer bilden zusammen mit der Entladungsröhre für die verwendete Mikrowellenfrequenz einen Resonator. Durch Vorsehen einer metallischen Drossel oder eines metallischen Ansatzes an der am Koaxialleiter angebrachten Endplatte wird der Mikrowellenverlust verringert. Eine ähnliche Anordnung wird in der DE 40 28 525 beschrieben.

Aus der US-PS 4 886 346 ist eine Anordnung von Mikrowellenbauteilen bekannt, mit der ein rotationssymmetrisches Mikrowellenfeld (E₀₁ Mikrowellenfeld) erzeugt werden kann, um damit ein rotationssymmetrisches Plasma in einem Glasrezipienten herzustellen. Zur Abstimmung der einzustrahlenden Mikrowellen weist die Einkoppelanordnung zwei Abstimmelemente auf, die für einen elektrisch stabilen Betrieb eine genaue Abstimmung im 1/10-mm-Bereich erforderlich machen. Längenänderungen in dieser Größenordnung können leicht auftreten, wenn die Temperatur des Resonators nicht genau stabilisiert wird.

Bei den relativ großen Abmessungen der Einkoppeleinrichtung ist dies sehr aufwendig. Außerdem ändert sich die Frequenz der für hohe Leistungen bevorzugt eingesetzten Magnetrons als Mikrowellenquelle mit der Temperatur, der Leistung und dem Alter. Dies führt ebenfalls zu einer Verstimmung, so daß die in die Reaktionskammer eingestrahlte Mikrowellenenergie nicht den gewünschten Werten entspricht.

Aus J. Physique 43, 1982, L 71 ist ein aus zum Teil prinzipiell den gleichen Bauteilen wie der US-PS 4 866 346 bestehende sogenannte Surfaguide-Struktur beschrieben, mit der ein rotationssymmetrisches Mikrowellenfeld zum Aufbau eines Plasmas erzeugt wird. Auch diese Anordnung benötigt zwei Abstimmelemente, die sehr genau eingestellt werden müssen und in sehr engen Toleranzen diese Einstellung beibehalten müssen.

Aus der US-PS 4 971 651 ist ein Verfahren und eine Vorrichtung zum Einkoppeln von Mikrowellen bekannt, wobei absorbierende oder streuende Bauteile derart in den Bereich der Mikrowellenstrahlung gebracht sind, daß elektromagnetische Felder, welche ohne diese Maßnahme örtlich die Plasmadichte erhöhen würden, bedämpft oder weggestreut werden. Auf diese Weise soll die Verteilung der Intensität des elektromagnetischen Feldes im Plasma und damit das Ergebnis der Mikrowellenbehandlung vergleichmäßigt werden. Gemäß der US-PS 4 971 651 müssen der Absorber oder das streuende Bauteil eine genau definierte Form aufweisen und an genau definierten Orten innerhalb des Mikrowellenleiters angeordnet sein, damit sie ihre Aufgaben erfüllen können. Form und Orte müssen in Vorversuchen ermittelt werden. Wird z.B. die Gestalt von Mikrowellenleiter und Entladungsgefäß geändert, müssen Lage und Gestalt des Absorbers bzw. des streuenden Bauteils neu bestimmt werden, damit eine Vergleichmäßigung gewährleistet ist. Die US-PS 4 971 651 gibt jedoch keinen Hinweis darauf, wie eine Mikrowelleneinkopplung in ein Plasma gestaltet sein muß, damit diese weitgehend tolerant gegen Änderungen von geometrischen Abmessungen und Leistungen der Koppelanordnung ist.

Es ist daher Aufgabe der Erfindung, eine Koppelanordnung für die Übertragung von Mikrowellenenergie aus einem Mikrowellenhohlleiter in eine Reaktionskammer zu finden, wobei die Koppelanordnung eine elektrisch stabile Abstimmung aufweisen soll, die in Grenzen tolerant ist gegen kritische Abmessungs- und Leistungsänderungen aufgrund von Temperaturschwankungen.

Diese Aufgabe wird einer Anordnung gemäß den Merkmalen von Anspruch 1 gelöst. Vorteilhafte Ausgestaltungen sind Gegenstand der Unteransprüche.

Üblicherweise werden die Mikrowellenbauteile aus gut leitendem Metall gefertigt, wenn ein Resonator hoher Güte erhalten werden soll. Entgegen dem allgemeinen Bestreben, die Resonatoren bezüglich ihrer Güte weiter zu verbessern, ist es hinsichtlich der Empfindlichkeit gegenüber Fehlanpassung infolge von Geometrieänderungen von Vorteil, wenn ein Resonator eingesetzt wird, der eine deutlich schlechtere Güte aufweist, als die üblicherweise eingesetzten Resonatoren. Die Güte der Einkoppeleinrichtung darf allerdings nicht soweit verschlechtert werden, daß eine Anregung des Plasmas in der Reaktionskammer nicht mehr stattfinden kann. Wenn die Leistungseinkoppelung unter Berücksichtigung dieser Punkte abgestimmt ist, kann auf eine Temperaturstabilisierung, wie sie sonst beim Stand der Technik erforderlich ist, weitgehend verzichtet werden. In einigen Anwendungsfällen reicht es aus, lediglich eine grobe Temperaturstabilisierung vorzunehmen.

Die Anordnung kann gemäß einer Ausführungsform dadurch unempfindlich gemacht werden, daß zumindest Teile des Koaxialleiters aus schlecht leitendem Material z.B. schlecht leitendem Metall hergestellt sind. Dies können Teile des Außenleiters und/oder des Innenleiters des Koaxialleiters sein.

Anstatt schlecht leitende Metalle zu verwenden, wie z.B. Stahl, können die Bauteile beispielsweise auch aus Graphit bestehen oder mit Graphit beschichtet sein.

Bei der Beschichtung von kalottenförmigen Substraten bildet das kalottenförmige Substrat zusammen mit einem weiteren Gefäßteil, insbesondere einer Metallplatte, das Vakumgefäß und somit die Reaktionskammer. Bei derart ausgebildeten Reaktionskammern kann die Metallplatte aus schlecht leitendem Material bestehen.

Gemäß einer weiteren Ausführungsform kann die Güte des Resonators dadurch verringert werden, daß in die Koppelanordnung ein Absorber eingebracht wird. Im Gegensatz zum Stand der Technik, wie er aus der US-PS 4 971 651 bekannt ist, ist die Lage und die Anordnung des Absorbers im Bereich der Koppelanordnung weitgehend unkritisch. Es ist somit möglich, bereits bestehende Bauteile im Koaxialleiter als Absorber auszubilden. Bei einem Koaxialleiter muß der Innenleiter, mit dem z.B. die E-Feld-Kopplung durchgeführt wird, mittels eines Stützringes am Außenleiter fixiert werden. Dieser Stützring kann gemäß einer besonderen Ausführungsform als Absorber ausgebildet sein, indem dieser aus dielektrischem Material gefertigt wird. Der Stützring kann z.B. aus Glaskeramik bestehen, was den Vorteil bietet, daß er trotz starker Erwärmung infolge der Absorption der Mikrowellenenergie sich nahezu nicht ausdehnt und somit sich und andere Bauteile durch Ausdehnung nicht beschädigt.

Es besteht auch die Möglichkeit, den Stützring aus nicht absorbierenden Material zu fertigen und ihn mit Wasser durchströmen zu lassen. In diesem Fall bietet es sich an, den Stützring zweiteilig aufzubauen und in eines der beiden Teile eine ringförmige Einfräsung für das Durchströmen des Wasser einzubringen. Der Stützring kann auch in Form eines wasserdurchflossenen kreisförmigen Rohres aus Kunststoff oder Glas gefertigt sein. Der Einsatz von Wasser im Bereich des als Absorber ausgebildeten Stützringes ist dann von Vorteil, wenn Mikrowellen im Bereich von 2,45 GHz eingesetzt werden. Für andere Mikrowellenfrequenzen sind andere geeignete, flüssige Absorber bekannt.

Der Abstand des Stützringes von der Reaktionskammer sollte mindestens 1/2 der verwendeten Mikrowellenfrequenz betragen, damit eventuell durch den Stützring angeregte nicht rotationssymmetrische Moden sich ausreichend stark im Bereich zwischen Absorber und Reaktionskammer abschwächen.

Eine weitere Möglichkeit, Mikrowellen zu absorbieren besteht darin, den Außenleiter ohne elektrischen Kontakt im Abstand von einigen Millimetern über einem leitendem Bauteil der Reaktionskammer enden zu lassen. Die Leistungsabstrahlung durch diesen so gebildeten Spalt wirkt ebenfalls als Verlustquelle. Eine Rückreflexion in den Bereich des Außenleiters kann durch handelsübliche Mikrowellenabsorber im Außenraum unterbunden werden.

Wenn der Durchmesser der Reaktionskammer durch den Durchmesser des kalottenförmigen Substrates bestimmt wird, so ist dieser kleinste Durchmesser des Übergangsbereiches kleiner zu wählen als der Durchmesser des kalottenförmigen Substrates. Der größte Durchmesser des Außenleiters des Übergangsabschnittes ist größer gleich dem Durchmesser der Reaktionskammer bzw. im Falle der Beschichtung von kalottenförmigen Substraten größer gleich dem Durchmesser des kalottenförmigen Substrates.

Damit der Wellenwiderstand sich nicht ändert, ist das Außenleiter-Innenleiter-Durchmesserverhältnis konstant. Je nach Ausgestaltung des Innenleiters erreicht man eine E-Feld- oder H-Feld-Kopplung.

Die engste Stelle des Übergangsabschnittes des Koaxialleiters dient als Wellentypfilter, so daß nur der rotationssymmetrische TEM-Wellentyp ausbereitungsfähig ist.

Der sich kontinuierlich erweiternde Übergangsbereich dient dazu, den Koaxialleiter stoßfrei auf einen Durchmesser aufzuweiten, der dem der Reaktionskammer entspricht. Dabei muß der Durchmesser allerdings so klein gewählt sein, daß nur die TEM-Mode für die verwendete Mikrowellenfrequenz im anschließenden zweiten Abschnitt ausbreitungsfähig ist.

Wenn die Reaktionskammer durch Kalotten mit einem maximalen Durchmesser von 50 mm definiert wird, so ist z.B. die 2,45 GHz Mikrowelle für die Beschichtung geeignet. Je nach Größe der zu beschichtenden Kalotten können deshalb auch andere Mikrowellenfrequenzen erforderlich werden.

Der zweite Abschnitt, der sich an den Übergangsabschnitt anschließt und bis in den Bereich der Reaktionskammer reicht, besteht aus einem Koaxialleiter mit konstantem Durchmesser D₂. Der Durchmesser ist so gewählt, daß sich nur die TEM-Koaxialmode ausbreiten kann.

Das in der Kalotte gezündete Plasma ist eine Fortsetzung des Innenleiters und ermöglicht so die weitere Ausbreitung der TEM-Welle.

Die Länge des zweiten Abschnittes des Koaxialleiters wird so gewählt, daß zusammen mit dem Abstimmelement eine optimale Leistungsanpassung an das System Koaxialleiter/Reaktionskammer gegeben ist.

Zwischen dem Übergangsbereich und dem Hohlleiter kann auch ein herkömmliches Koaxialkabel eingesetzt werden, das dann die Aufgabe als Wellentypfilter erfüllt.

Beispielhafte Ausführungsformen werden nachfolgend anhand der Zeichnungen näher erläutert.

Es zeigen:
- Figur 1: die schematische Darstellung einer Einkoppelanordnung
- Fig. 2: die schematische Darstellung einer Einkoppelanordnung gemäß einer weiteren Ausführungsform und
- Figur 3: eine Darstellung des Leistungsreflektionsfaktors in Abhängigkeit von der Länge des Koaxialleiters für verschiedene Verlustfaktoren.

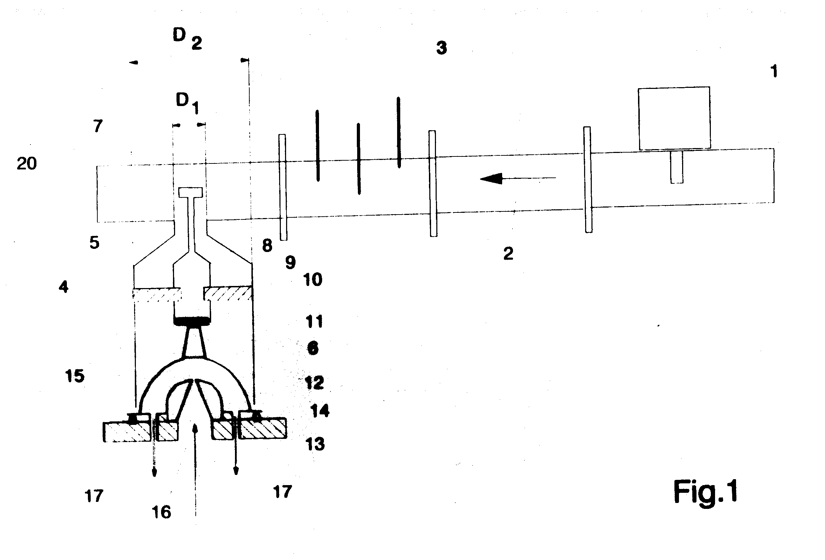

In der Figur 1 ist eine Mikrowelleneinrichtung mit einer Einkoppelanordnung schematisch dargestellt. Ein Magnetron ist an einem Hohlleiter 2 angeschlossen, der als Einwegleitung ausgebildet ist. Im Hohlleiter 2 ist vor dem Ort, wo die Einkopplung erfolgt, ein Dreischraubentransformator 3 als Abstimmelement angeordnet. Die Einkoppelanordung weist einen Koaxialleiter 4 mit einem Innenleiter 7, 8, 9, und einem Außenleiter 5, 6 auf. Der Innenleiter 7 ragt in den Mikrowellenhohlleiter zur E-Feld Kopplung hinein und setzt sich nach unten in einem Übergangsabschnitt 5, 8 und einem Endabschnitt 6, 9 fort. Der Innenleiter weitet sich im Übergangsabschnitt 8 kontinuierlich auf, bis er den Durchmesser des Endabschnitts 9 erreicht hat. Dementsprechend ist auch der Übergangsbereich 5 des Außenleiters ausgebildet, wobei das Verhältnis der Durchmesser der Übergangsabschnitte 5, 8 konstant ist. Der kleinste Durchmesser D₁ des Übergangsbereiches 5 des Außenleiters ist kleiner als der Durchmesser der zu beschichtenden Kalotte 12. Der größte Durchmesser D₂ des Übergangsbereiches 5 des Außenleiters ist größer gleich dem Durchmesser der Kalotte 12.

Der zweite Abschnitt 6 besitzt einen konstanten Außendurchmesser D₂.

Der Innenleiterendabschnitt 9 wird von einem Stützring 10 am Außenleiterabschnitt 6 gehalten. Dieser Stützring 10 ist als Absorber ausgebildet und verringert die Güte des Resonators, der in der Figur 1 durch den Abschnitt 20 des Mikrowellenhohlleiters 2, den Koaxialleiter 4 und die Reaktionskammer 14 gebildet wird. Das Ende des Endabschnittes 9 des Innenleiters ist mit einem Dichtelement 11 versehen, das auf dem Hals der Kalotte 12 aufsitzt und diesen verschließt. Die Kalotte 12 bildet zusammen mit der Metallplatte 13 die Vakuumkammer 14, in der die Beschichtungsreaktion stattfindet. Zu diesem Zweck ist die Platte 13 mit einem Gaseinlaß 16 und peripheren Gasauslässen 17 versehen.

Die Bauteile 5, 6, 8, 9 können auch aus schlecht leitendem Material gefertigt sein oder beispielsweise mit Graphit beschichtet sein.

Der Stützring 10, der in der hier gezeigten Darstellung als Ringplatte ausgebildet ist und senkrecht zur Achse des Koaxialleiters 4 eingebaut ist, kann auch mit Wasser durchspült sein. Die Position des Stützringes 10 ist unkritisch und er kann sowohl weiter oben als auch weiter unten gegenüber der hier gezeigten Darstellung angeordnet sein, wobei jedoch ein Mindestabstand von λ/2 der verwendeten Mikrowellenfrequenz zwischen Absorber 10 und Reaktionskammer 14 eingehalten werden sollte.

Eine weitere Möglichkeit die Güte des Resonators zu verschlechtern ist ebenfalls in der Figur 1 dadurch angedeutet, daß der Außenleiter 6 nicht mit der Metallplatte 13 in Berührung kommt, sondern oberhalb dieser Platte endet. Dadurch bildet sich ein Ringspalt 15, durch den die Mikrowellenenergie abgestrahlt werden kann. Durch einen nicht dargestellten Absorber im Außenraum wird verhindert, daß die abgestrahlte Mikrowellenenergie in den Außenbereich gelangt.

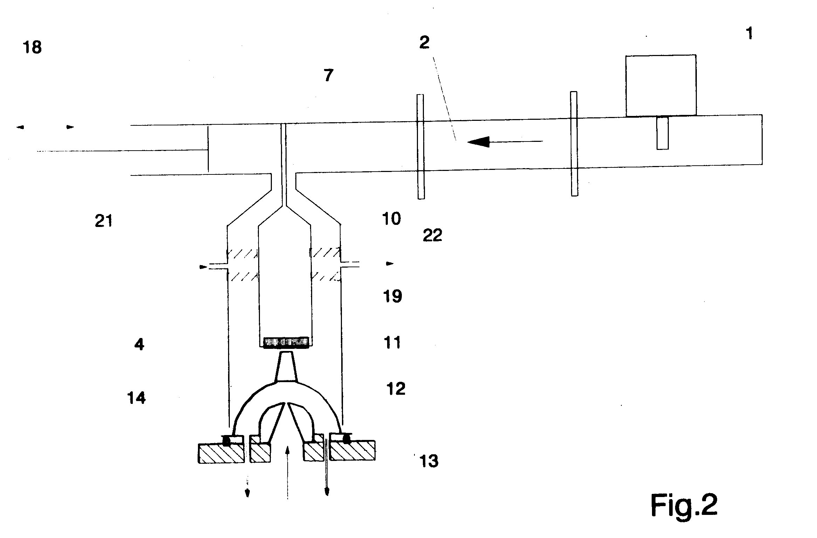

Die Figur 2 unterscheidet sich von der Figur 1 dadurch, daß anstelle eines Dreischraubentransformators als Abstimmelement ein Kurzschlußschieber 18 im Mikrowellenhohlleiter 2 angeordnet ist und daß der Innenleiter 7 mit der Wand des Mikrowellenhohlleiters 2 zur H-Feld-Kopplung verbunden ist. Weiterhin ist der Absorber 10 zweiteilig als ringförmiges Rohr 19 ausgebildet und besitzt einen Zulauf 21 und einen Ablauf 22, so daß der Absorber z.B. mit Wasser durchströmt werden kann.

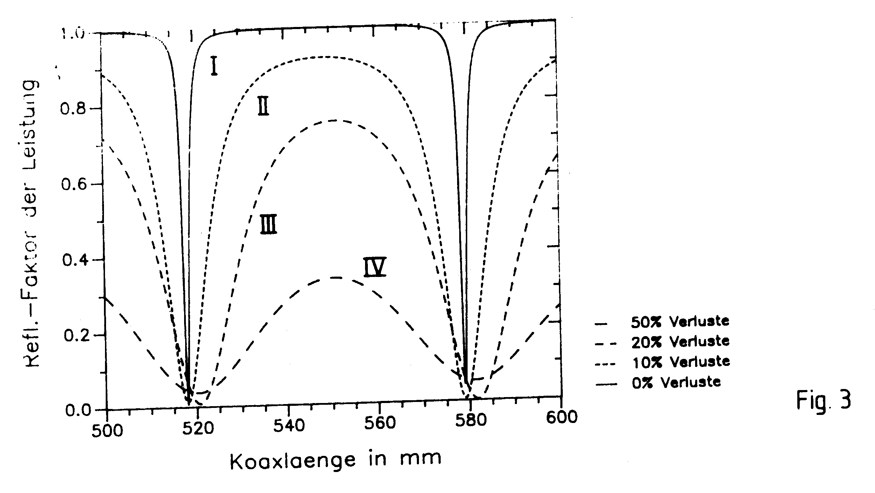

In der Figur 3 ist der Reflektionsfaktor der Leistung in Abhängigkeit von der Länge des Koaxialleiters 4 dargestellt. Wenn eine Koaxialleiterlänge von etwa 518 mm verwendet wird, so zeigt der Resonator bei einer Frequenz von 2,45 GHz bei optimaler Abstimmung ein Verhalten gemäß der Kurve I. Die reflektierte Leistung ist dann im Bereich von 518 mm gleich Null, d.h. die gesamte Leistung steht für das Zünden und Aufrechterhalten des Plasmas zur Verfügung.

Wenn bei diesem idealen Resonator durch Temperaturschwankungen die Koaxialleiterlänge verändert, nimmt bereits bei einem 1/10 mm die Reflektion sprungartig zu. Eine Änderung der Koaxialleiterlänge um 1 mm bedeutet eine Erhöhung des Reflektionsfaktors um 50 %. Wenn die Güte des Resonators verschlechtert wird, z.B. durch den Einbau eines Absorbers so ändert sich der Rekflektionsfaktor deutlich weniger. Wenn ein Absorber mit einem Verlust von nur 10 % eingebaut wird (s. Kurve II), so wird die gesamte Anordnung bereits 6 mal unempfindlicher gegenüber einer gleichen Längenänderung. Durch die Wahl des Absorbers kann somit die Empfindlichkeit gesteuert werden, wobei mi zunehmenden Verlusten die Empfindlichkeit des Resonators bezüglich der Längenänderung immer geringer wird. Auf zusätzliche Temperaturstabilisierung kann somit verzichtet werden, wodurch die gesamte Anordnung kostengünstiger wird.

### BEZUGSZEICHENLISTE

- 1: Magnetron
- 2: Hohlleiter
- 3: Schraubentransformator
- 4: Koaxialleiter
- 5: Erster Abschnitt Außenleiter
- 6: Zweiter Abschnitt Außenleiter
- 7: Innenleiter
- 8: Übergangsbereich Innenleiter
- 9: Endabschnitt Innenleiter
- 10: Absorber
- 11: Dichtelement
- 12: kalottenförmiges Substrat
- 13: Metallplatte
- 14: Reaktionskammer
- 15: Ringspalt
- 16: Gaseinlaß
- 17: Gasauslaß
- 18: Schieber
- 19: mit Flüssigkeit durchflossenes Rohr
- 20: Endabschnitt des Mikrowellenhohlleiters
- 21: Zulauf
- 22: Ablauf

## Patentansprüche

1. Anordnung zur Einkopplung von Mikrowellenenergie in eine Reaktionskammer, insbesondere in eine Plasma-CVD-Beschichtungskammer, mit einem Mikrowellenhohlleiter und einem zwischen Mikrowellenhohlleiter und Reaktionskammer angeordneten Koaxialleiter, wobei zumindest
der Koaxialleiter (4) zusammen mit der Reaktionskammer (14) für die verwendete Mikrowellenfrequenz einen Resonator bildet, dadurch gekennzeichnet,
daß der Resonator mit vorgegebenen Verlusten behaftet ist,
daß der Koaxialleiter (4) mindestens zwei Abschnitte (5, 6, 8, 9) aufweist,
daß der erste Abschnitt (5, 8) mit dem Mikrowellenhohlleiter (2) verbunden ist und als Übergangsabschnitt mit einem sich kontinuierlich in Richtung zur Reaktionskammer (14) hin vergrößernden Durchmessern von Innenleiter (8) und Außenleiter (5) ausgebildet ist, wobei der kleinste Durchmesser D₁ des Außenleiters kleiner als der Durchmesser der Reaktionskammer (14) und der größte Durchmesser D₂ des Außenleiters größer gleich dem Durchmesser der Reaktionskammer (14) ist und
daß der zweite Abschnitt (6, 9) aus einem Koaxialleiterstück mit konstantem Durchmesser D₂ besteht.

2. Anordnung nach Anspruch 1, dadurch gekennzeichnet, daß zumindest Teile des Koaxialleiters (4) aus schlecht leitendem Material bestehen.

3. Anordnung nach Anspruch 1 oder 2, dadurch gekennzeichnet, daß zumindest ein die Reaktionskammer (14) bildendes Bauteil (13) aus schlecht leitendem Material besteht.

4. Anordnung nach einem der Ansprüche 1 bis 3, dadurch gekennzeichnet, daß ein zusammen mit einem zu beschichtenden kalottenförmigen Substrat (12) die Reaktionskammer (14) bildendes Gefäßteil (13) aus schlecht leitendem Material besteht.

5. Anordnung nach einem der Ansprüch 1 bis 4, dadurch gekennzeichnet, daß der Koaxialleiter (4) Graphit aufweist.

6. Anordnung nach einem der Ansprüch 1 bis 5, dadurch gekennzeichnet, daß im Koaxialleiter (4) ein Mikrowellenabsorber (10) angeordnet ist.

7. Anordnung nach Anspruch 6, dadurch gekennzeichnet, daß der Mikrowellenabsorber (10) ein den Innenleiter (9) des Koaxialleiters (4) haltender Stützring ist.

8. Anordnung nach Anspruch 7, dadurch gekennzeichnet, daß der Stützring aus Glaskeramik besteht.

9. Anordnung nach Ansprüche 7, dadurch gekennzeichnet, daß der Stützring als mit Flüssigkeit durchflossenes Rohr (19) ausgebildet ist.

10. Anordnung nach Anspruch 9, dadurch gekennzeichnet, daß das Rohr aus Glas oder Kunststoff besteht.

11. Anordnung nach einem der Ansprüche 7 bis 10, dadurch gekennzeichnet, daß der Abstand des Stützringes von der Reaktionskammer (14) mindestens eine halbe Wellenlänge der verwendeten Mikrowellenfrequenz beträgt.

12. Anordnung nach Anspruch 11, dadurch gekennzeichnet, daß der Abstand eine Wellenlänge der verwendeten Mikrowellenfrequenz beträgt.

13. Anordnung nach einem der Ansprüche 1 bis 12, dadurch gekennzeichnet, daß der Außenleiter (6) des Koaxialleiters (4) beabstandet zu einem leitenden Bauteil (13) der Reaktionskammer (14) angeordnet ist.

14. Anordnung nach einem der Ansprüche 1 bis 13, dadurch gekennzeichnet, daß Teile des Mikrowellenhohlleiters (2) Bestandteil des Resonators sind und daß der Mikrowellenhohlleiter (2) als Abstimmelement lediglich einen Dreischraubentransformator (3) aufweist.

15. Vorrichtung nach einem der Ansprüche 1 bis 13, dadurch gekennzeichnet, daß ausschließlich der Koaxialleiter (4) mit der Reaktionskammer (14) den Resonator bildet und daß der Mikrowellenhohlleiter als Abstimmelement lediglich einen Kurzschlußschieber (18) aufweist.

16. Anordnung nach einem der Ansprüche 1 bis 15, dadurch gekennzeichnet, daß das Außenleiter-Innenleiterdurchmesserverhältnis des ersten Abschnittes (5, 8) des Koaxialleiters (4) konstant ist.

17. Anordnung nach einem der Ansprüche 1 bis 16, dadurch gekennzeichnet, daß zwischen dem Mikrowellenhohlleiter (2) und dem ersten Abschnitt (5, 8) des Koaxialleiters (4) ein Koaxialkabel angeordnet ist, das Bestandteil des Resonators ist.
